# EUROPEAN PATENT APPLICATION

(11) **EP 3 054 437 A2**
(43) Date of publication of application: **10.08.2016**
(21) Application number: 14851187.6
(22) Date of filing: 06.10.2014
(51) Int. Cl.: G08C 17/02, G01R 21/00

(54) **DIGITAL POWER METER READER SYSTEM FOR REMOTE METER READING, AND UTILIZING METHOD USING SAME**

(30) Priority: 04.10.2013 KR 20130118813
(71) Applicant: Tide Co., Ltd., Seoul 153-709 (KR)
(72) Inventor: JEOUN, Hee Yeoun, Seoul 153-821 (KR)
(74) Representative: Garavelli, Paolo
(86) International application number: PCT/KR2014/009369
(87) International publication number: WO 2015/050415

(57) **Abstract**

The present invention relates to: a digital power meter reader system for remote meter reading, which is capable of completing power meter reading at a distance by utilizing conventional mechanical power meter readers provided in respective houses; and a utilizing method using the same. Particularly, the present invention relates to a digital power meter reader system for remote meter reading and a utilizing method using the same, wherein the system can automatically accomplish a series of all the steps of: photographing a mechanical power meter reader with a smart phone or a mobile phone; scanning the photographed data through an embedded application program; transferring the scanned data on an amount of a used current (=amount of used power) to the digital power meter reader through NFC such that the transferred data is computed and confirmed in a management server through a DCU; and re-transferring the data to the digital power meter reader so as to confirm the data. Thus, an amount of power used in each house is capable of being easily calculated even at a distance, and a user of the power who has confirmed the amount in a convenient manner can request corrections in a more precise and safe manner by confirming a difference between the digital power meter reader and the mechanical power meter reader.

## Description

### TECHNICAL FIELD

The present invention relates to a digital power meter reader system for remote meter reading, which is capable of completing power meter reading at a distance by utilizing conventional mechanical power meter readers provided in respective houses, and a utilizing method using the same.

Particularly, the present invention relates to a digital power meter reader system for remote meter reading, and a utilizing method using the same, wherein the system can automatically accomplish a series of all the steps of: photographing a mechanical power meter reader with a smart phone or a mobile phone; scanning the photographed data through an embedded application program; transferring the scanned data on an amount of a used current (=amount of user power) to the digital power meter reader through NFC such that the transferred data is computed and confirmed in a management server through a DCU; and re-transferring the data to the digital power meter reader so as to confirm the data. Thus, an amount of power used in each house is capable of being easily calculated even at a distance, and a user of the power who has confirmed the amount in a convenient manner can request corrections in a more precise and safe manner by confirming a difference between the digital power meter reader and the mechanical power meter reader.

### BACKGROUND

It is common that electric power suppliers (for example, Korean Electric Power Corporation, (hereinafter, KEPCO)) have metermen to charge residents, that is, users of electric power, for the use of power in their respective houses, and make profits. This meter reading method costs much to have many human resources and also always requires separate billing methods since the charge is not calculated in real time.

Therefore, to solve these problems, a related-art method uses a remote meter reader which is capable of remote communication and achieves goals at a high communication cost. The related-art method has been developed, aiming at reducing cost but spending a lot of money.

A related-art remote meter reading system and a method thereof will be explained briefly. Korean Patent Application No. 10-2003-0097674 discloses "Remote Load Control Type Electronic Watt-Hour Meter System Using Power Line Method."

As shown in the drawings, the related-art electronic watt-hour meter system includes an electronic watt-hour meter 100, other meters 200 which are installed in respective houses to measure gas, water, hot water, heat, and cooling, a remote meter reading system 300, a home network system 400, and a portable terminal 500. The electronic watt-hour meter 100 includes: a current detection unit 110 and a voltage detection unit 120 which detect an input current and an input voltage to calculate an amount of used power; a power supply unit 130 to supply operation power necessary for the electronic watt-hour meter; a main circuit unit 150 which receives energy values added in other meters 200 for measuring gas, water, hot water, heat, and cooling as a pulse, controls a program for calculating, storing, and outputting the added energy values of the installed meters, and controls an external output and communication module; and a power line communication module 140 to transmit and receive data between the main circuit unit 150 and the remote meter reading system 300 through power line communication.

Herein, the main circuit unit 150 includes: an A/D conversion unit 151 which converts analogue signals of the current and the voltage detected by the current detection unit 110 and the voltage detection unit 120 into digital signals; a calculation unit 152 which calculates an amount of power based on input values of the instantaneous voltage and current converted through the A/D conversion unit 151; a program control unit 153 which temporarily stores the instantaneous values of the amount of power calculated in the calculation unit 152, and controls overall application operations such as displaying, input/output, communication, etc.; a storage unit 154 which stores the instantaneous values of the amount of power calculated in the calculation unit 152, and application programs of the electronic watt-hour meter 100; a display unit 155 which displays the amount of used power to allow a user to see through a device of the watt-hour meter, such as an LCD, under control of the program control unit 153; an input control unit 156 which controls a data value necessary for adjusting a program input and a calibration factor; an output control unit 157 which generates signals like a pulse for an external device in proportion to the amount of used power added by the program control unit 153; and a communication control unit 158 which controls communication by exchanging data with the power line communication module 140, and further includes a wireless communication module 159 which enables data to be exchanged between the portable terminal 500 and the program control unit 153. The user may communicate the electronic watt-hour meter 100 through the wireless communication module 159 using the portable terminal 500.

That is, the present invention aims at controlling amounts of a variety of energy such as electric power, gas, water, hot water, heat, etc. using a portable terminal. To achieve this, various elements should be installed. However, it is difficult to install the elements such as a separate main circuit unit.

Therefore, it is difficult to control the amount of used energy in the related-art methods.

### DISCLOSURE OF INVENTION

### TECHNICAL PROBLEM

One or more exemplary embodiments provide a digital power meter reader system for remote meter reading, which is capable of completing power meter reading at a distance by utilizing conventional mechanical power meter readers provided in respective houses, and a utilizing method using the same.

One or more exemplary embodiments also provide a digital power meter reader system for remote meter reading, and a utilizing method using the same, wherein the system can automatically accomplish a series of all the steps of: photographing a mechanical power meter reader with a smart phone or a mobile phone; scanning the photographed data through an embedded application program; transferring the scanned data on an amount of a used current (=amount of user power) to the digital power meter reader through NFC such that the transferred data is computed and confirmed in a management server through a DCU; and re-transferring the data to the digital power meter reader so as to confirm the data. Thus, an amount of power used in each house is capable of being easily calculated even at a distance, and a user of the power who has confirmed the amount in a convenient manner can request corrections in a more precise and safe manner by confirming a difference between the digital power meter reader and the mechanical power meter reader.

According to an aspect of an exemplary embodiment, there is provided a digital power meter reader system for remote meter reading, which easily reads an amount of used power without a meterman reading a power meter, the system including: a digital power meter reader 20 which is connected to a mechanical power meter reader 10 installed in each house (H), and measures an amount of power flowing into the house through a CT sensor 23 disposed therein and transfers the measured data to a DCU 30 through PLC; the DCU 30 which transfers the amount of used power and relevant data transmitted from the digital power meter reader 20 of each house to a server 40 for computing power through a mobile communication network 31, and which transfers a signal for correcting the amount of used power of the digital power meter reader 20 through the PLC according to a control signal transferred from the server 40; and the server 40 (for example, a server of KEPCO) which has a charging system for charging each house for supplied power, and which computes a usage charge according to charging data transferred from the digital power meter reader 20 and controls the digital power meter reader 20 and the DCU 30.

The digital power meter reader 20 of the digital power meter reader system for remote meter reading of the present invention may include: the CT sensor 23 which examines a pulse of an inflowing current and measures an amount of the inflowing current; an A-DC converter 24 which converts analogue usage data measured based on an amount of current into digital data; a key button 25 which is clicked to set the digital power meter reader 20 and installed to correct or input usage data; a PLC module 26 which converts, filters, and couples a signal and data to transfer the usage data measured by the CT sensor 23 to the DCU 30 through the PLC; an LCD panel 27 which displays the input amount of used power and displays an amount of power used in the meantime, and expresses a control signal transferred from a CPU 21; and the CPU 21 and a control program 22 embedded in the CPU 21 which control all of the above-described elements, and control to convert a current amount pulse read by the CT sensor 23 using the A-DC converter 24, transfer the current amount pulse to the DCU 30 through the PLC module 26, and display the amount of used current expressed on the LCD panel 27 in response to a control signal transferred from the server 40 and the DCU 30, and the digital power meter reader may be configured to measure the amount of used current, correct the amount of used current, and transfer the amount of used current to the server 40.

The digital power meter reader 20 of the digital power meter reader system for remote meter reading of the present invention may include: the CT sensor 23 which examines a pulse of an inflowing current and measures an amount of the inflowing current; a mobile phone 50 which is a terminal of a user of the system, and which scans a photo taken for the mechanical power meter reader 10, extracts photo data through an application program 51, and transfers the photo data to an NFC module 60 of the digital power meter reader 20 using an NFC chip 52 embedded in the mobile phone 50; an A-DC converter 24 which converts analogue usage data measured based on an amount of used current into digital data; a key button 25 which is clicked to set the digital power meter reader 20 and installed to correct or input usage data; a PLC module 26 which converts, filters, and couples a signal and data to transfer the usage data measured by the CT sensor 23 to the DCU 30 through the PLC; an LCD panel 27 which displays the input amount of used power and displays an amount of power used in the meantime, and expresses a control signal transferred from a CPU 21; and the CPU 21 and a control program 22 embedded in the CPU 21 which control all of the above-described elements, and control to convert a current amount pulse read by the CT sensor 23 using the A-DC converter 24, transfer the current amount pulse to the DCU 30 through the PLC module 26, and display the amount of used current expressed on the LCD panel 27 in response to a control signal transferred from the server 40 and the DCU 30, and which generate a control signal for transferring, to the DCU 30, data of an amount of used power of the mechanical power meter reader transferred to the NFC module 60, and the digital power meter reader may be configured to measure an amount of used current, correct the amount of used current, and transfer the amount of used current to the server 40.

According to exemplary embodiments of the present disclosure, there is provided a utilizing method using a digital power meter reader 20 system for remote meter reading, which reads an amount of used current at a remote distance without a meterman reading a meter, and computes a charge, the method including: a first step of setting, in each house (H), a digital power meter reader 20 for analyzing an inflowing power pulse through a CT sensor 23 and analyzing an amount of used current (A100); a second step of synchronizing an amount of used current read through a mechanical power meter reader 10 and an amount of used current of the digital power meter reader 20, and transferring the synchronized amount of used current to a server 40 for managing (A110); and a third step of, when there is a discrepancy in the amounts of used current displayed on both meter readers while power is used in each house (H), transmitting the discrepancy to the server 40, and checking and correcting the amount of used current (A120).

In the utilizing method using the digital power meter reader 20 system of the present invention, the step (A110) of synchronizing the meter readers and transmitting synchronized data to the server 40 may proceed with synchronizing by a user using an application program 51 of a mobile phone 50 or using a key button 25 of the digital power meter reader 20. When the application program 51 of the user mobile phone 50 is selected as a synchronizing method, the step of synchronizing may include: an A step of photographing the mechanical power meter reader 10 with a camera on the application program 51 using the user mobile phone 50, and checking an amount of current used in the meantime (B120); a B step of scanning, by the user mobile phone 50 and the application program 51, the taken photo, and acquiring usage data (B130); a C step of bringing, by the user, the mobile phone 50 close to the digital power meter reader 20, and receiving, by the digital power meter reader 20, data of an amount of used current using an NFC chip 52 and an NFC module 60 by clicking a transfer button on the application program 51, and transferring the data to a DCU 30 through PLC (B140); a D step of acquiring, by the DCU 30, data necessary for using the system of each house, and transferring the data to the server 40 through a mobile communication network 31 (B150); an E step of recognizing, by the server, the transferred data as an amount of current used in each house (H), and then generating a control signal (B160); and an F step of transferring the control signal to the digital power meter reader 20 through the DCU 30 using the PLC to correct or check the amount of used current of the digital power meter reader 20, and displaying the amount of used current on an LCD panel 27 (B170), and may synchronize the amounts of used current between the server and the digital power meter reader. When the key button 25 of the digital power meter reader 20 is selected as a synchronizing method, the step of synchronizing may include: an *a* step of inputting an amount of used current of the mechanical power meter reader 10 which is checked by a meterman at a manager side managing the server 40 with meterman's eyes using the key button 25 of the digital power meter reader 20 (B180); a *b* step of transferring the inputted amount of used current to a DCU 30 through PLC (B190); a c step of acquiring, by the DCU 30, data necessary for using the system of each house (H) and transferring the data to the server 40 through the mobile communication network 31 (B150); a *d* step of recognizing, by the server 40, the transferred data as an amount of current used in each house (H) in the meantime, and then generating a control signal (B160); and an e step of transferring the control signal to the digital power meter reader 20 through the DCU 30 using the PLC to correct or check the amount of used current of the digital power meter reader 20, and displaying the amount of used current on an LCD panel 27 (B170), and may synchronize the amounts of used current between the server 40 and the digital power meter reader 20.

In addition, in the utilizing method using the digital power meter reader system of the present invention, the step (A120) of, when there is a discrepancy in the amounts of used current displayed on both meter readers while power is used in each house (H), transmitting the discrepancy to the server 40, and checking and correcting the amount of used current may include: a first step of identifying, by the user, the discrepancy in the amounts of used current between the mechanical power meter reader 10 and the digital power meter reader 20 using the application program 51 of the mobile phone 50, and photographing (B210); a second step of displaying a difference in the amounts of used current and costs caused by the discrepancy between both meter readers on the application program 51 (B220); a third step of requesting, by the user, correction by clicking a button on the application program 51 of the mobile phone 50 (B230); a fourth step of scanning a taken photo and reading as data indicating the discrepancy in the amounts of used current, and transferring data for requesting correction to a DCU 30 using NFC (B240); a fifth step of acquiring, by the DCU 30, the data for requesting the correction, and transferring the data to the server 40 using a mobile communication network 31 (B250); a sixth step of recognizing, by the server 40, the transferred data as an amount of current used in the house requesting the correction, and then generating a control signal (B260); and a seventh step of transferring the control signal to the digital power meter reader 20 through the DCU 30 using PLC to correct the amount of used current of the digital power meter reader 20, and displaying and checking the amount of used current on an LCD panel 27 (B270), and may synchronizes the amounts of used current between the server 40 and the digital power meter reader 20.

The present invention can easily check the amount of used power and also check the state of the digital power meter reader installed in each house even at a remote distance. Therefore, it is easy to collect a bill on the amount of used power and also easy to manage, and there is an advantage that cost for utilizing the system can be reduced since a separate meterman is not required.

In addition, all of the systems can be utilized by simply installing the digital power meter reader proposed in the present invention and installing an application program on the smart phone (=mobile phone), and thus it is easy to use the system.

In addition, according to the present invention, there is an advantage that additional extra cost is not incurred since contactless short-range wireless communication or an NFC chip already mounted in the smart phone is used.

### BRIEF DESCRIPTION OF THE DRAWINGS

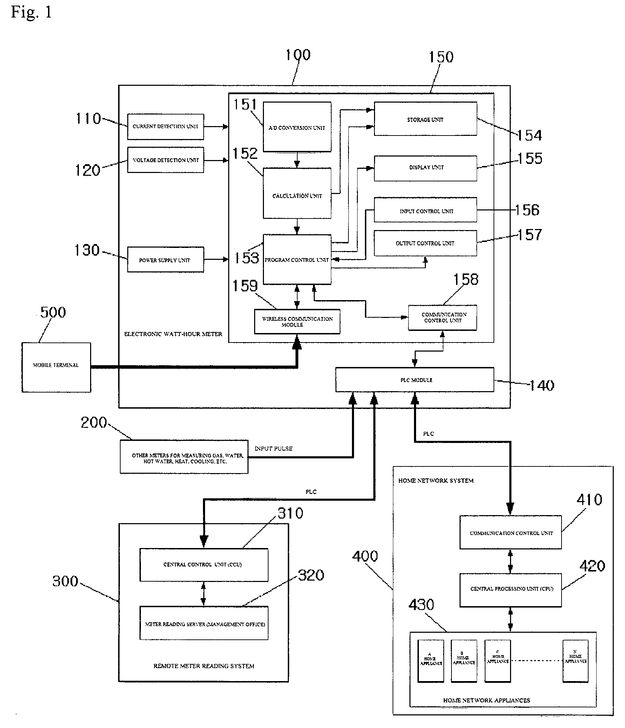

FIG. 1 is a view showing a configuration of a related-art method for reading a meter of an amount of used power at a remote distance, the application of which was filed in KIPO;

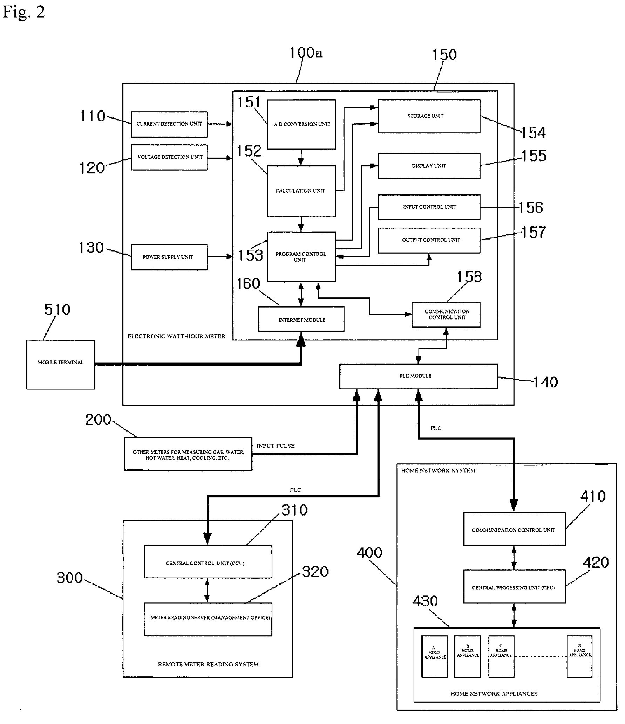

FIG. 2 is a view showing the configuration of FIG. 1 in detail;
FIG. 3 is a view showing a configuration of a remote meter reading system according to the present invention;
FIG. 4 is a view showing a configuration of a system according to the present invention in the simplest way;
FIG. 5 is a view showing a digital power meter reader forming a main part of the system of the present invention in detail;
FIG. 6 is a view showing the digital power meter reader forming the main part of the system of the present invention, to which an NFC communication module is added;
FIG. 7 is a sequence diagram showing a meter reading method for reading an amount of used power at a remote distance using the system of the present invention;
FIG. 8 is a sequence diagram showing a process of transmitting synchronization between meter readers to a server in the meter reading method of the present invention; and
FIG. 9 is a sequence diagram showing steps which are used when synchronization between meter readers is necessary while the system of the present invention is used.

### DETAILED DESCRIPTION OF EXEMPLARY EMBODIMENTS OF THE INVENTION

A digital power meter reader system for remote meter reading according to the present invention includes: a digital power meter reader 20 which is connected to a mechanical power meter reader 10 installed in each house (H), and measures an amount of power flowing into the house through a CT sensor 23 disposed therein and transfers the measured data to a DCU 30 through PLC; the DCU 30 which transfers the amount of used power and relevant data transmitted from the digital power meter reader 20 of each house to a server 40 for computing power through a mobile communication network 31, and which transfers a signal for correcting the amount of used power of the digital power meter reader 20 through the PLC according to a control signal transferred from the server 40; and the server 40 (for example, a server of KEPCO) which has a charging system for charging each house for supplied power, and which computes a usage charge according to charging data transferred from the digital power meter reader 20 and controls the digital power meter reader 20 and the DCU 30, and the system can easily read an amount of used power without a meterman reading a power meter.

The present invention relates to a system which can easily analyze and read an amount of power used in respective houses even at a remote distance, so that meter reading cost can be efficiently reduced, and a meter reading method thereof.

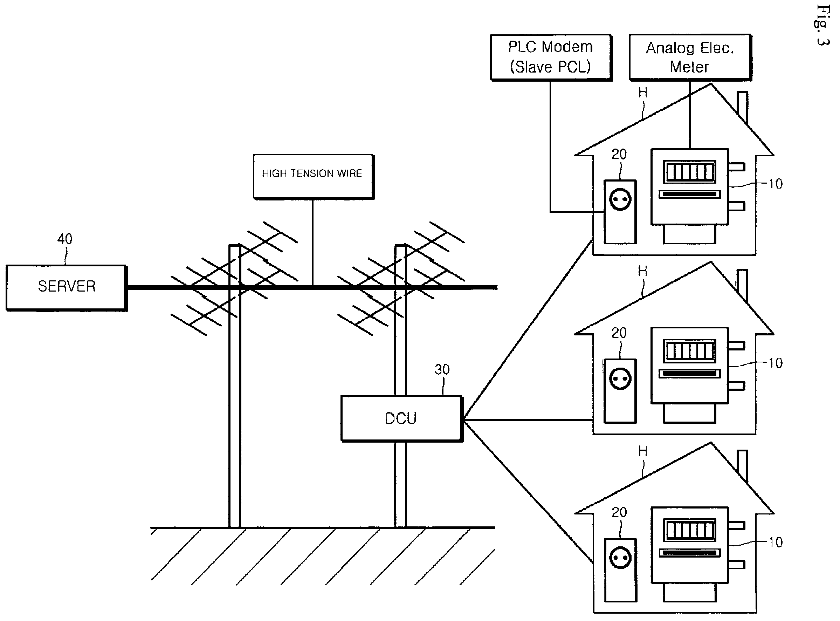

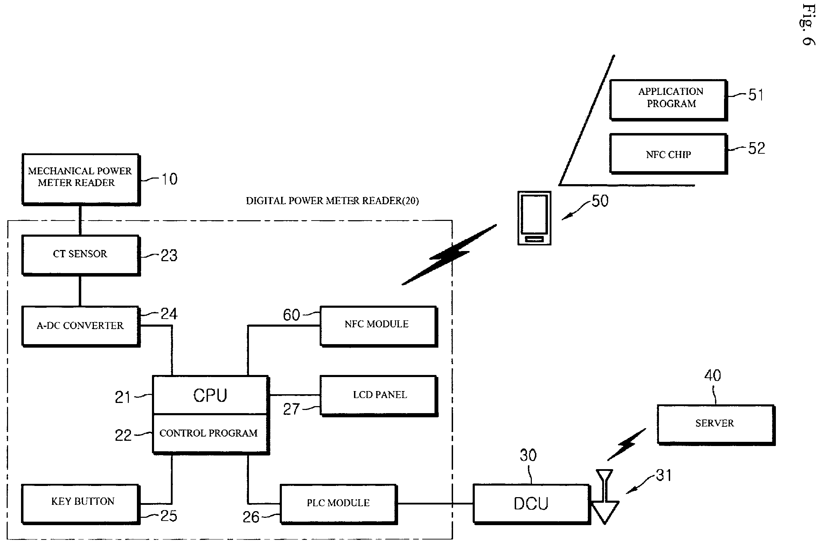

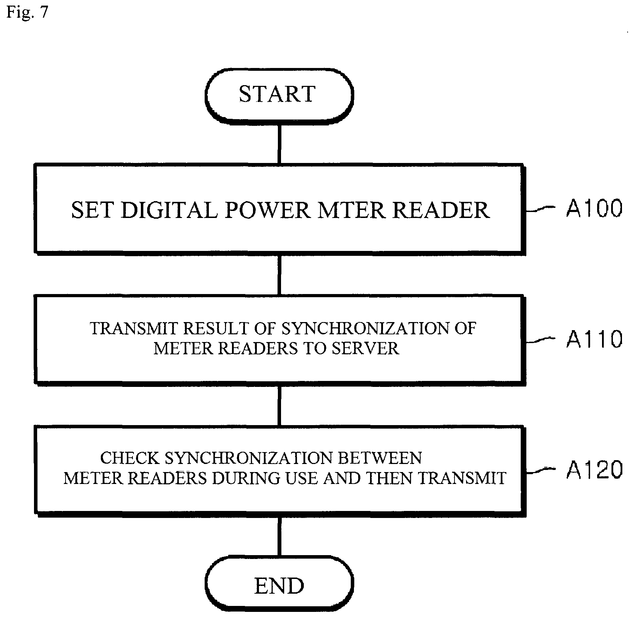

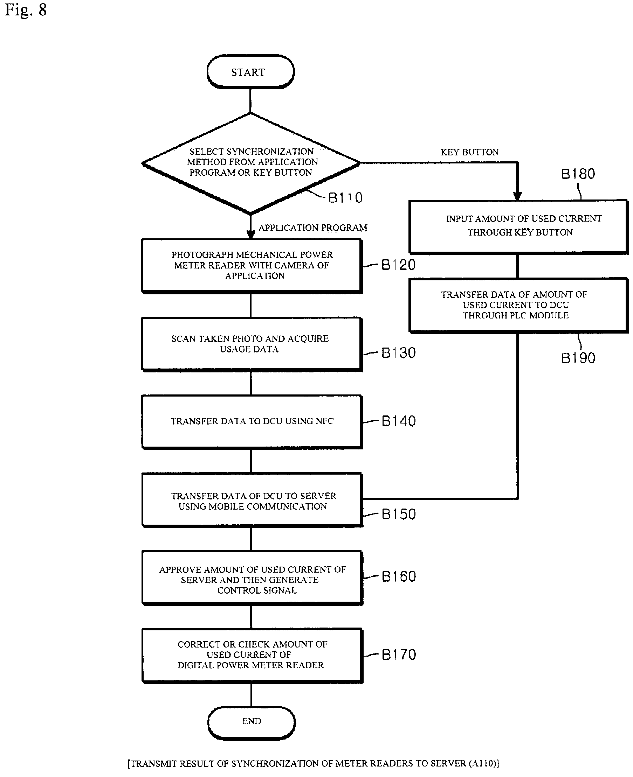

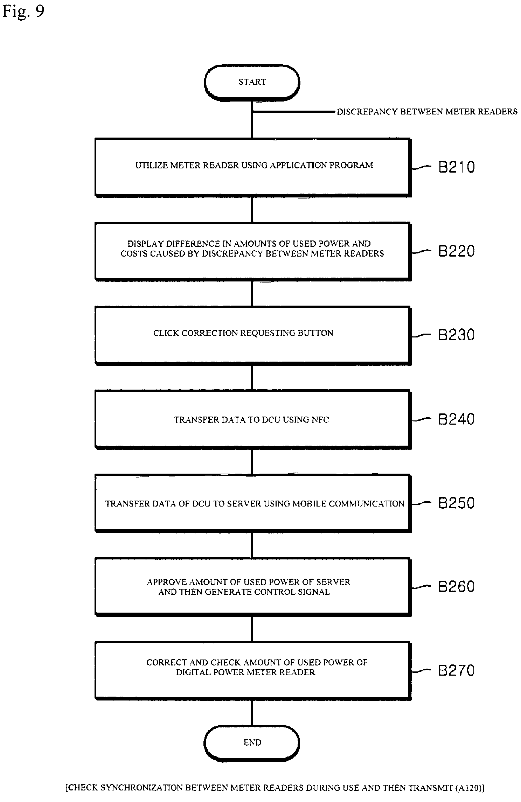

Therefore, a configuration of the present invention and an operating method thereof will be explained in detail with reference to FIGs. 3 to 9.

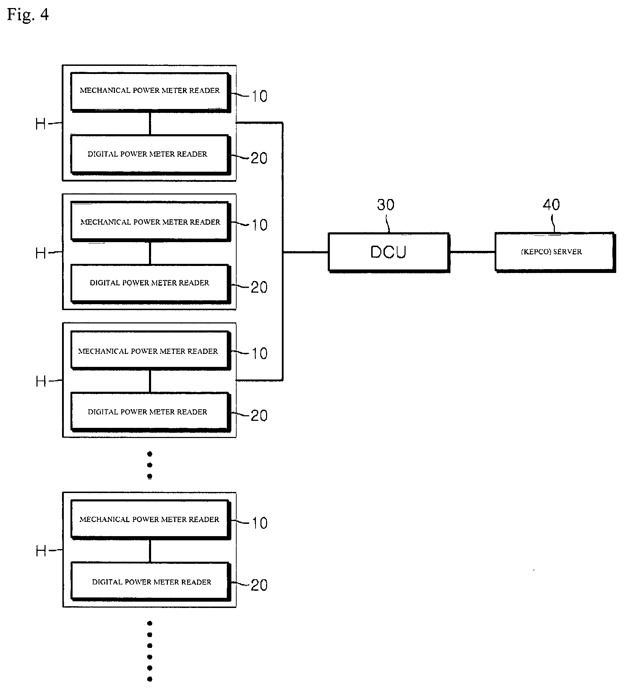

As shown in FIGs. 3 and 4, the present invention includes: a digital power meter reader 20 which is connected with a mechanical power meter reader 10 installed in each house (H), and measures an amount of power supplied to the house through a CT sensor 23 installed therein and transfers corresponding data to a Data Concentrator Unit (DCU) 30 through Power Line Communication (PLC); the DCU 30 which transfers the amount of used power and relevant data transferred from the digital power meter reader 20 of each house to a server 40 for computing power through a mobile communication network 31, and transfers a signal to correct the amount of used power of the digital power meter reader 20 through PLC according to a control signal transferred from the server 40; and the server 40 (for example, a server of KEPCO) which has a charging system for charging respective houses for supplied power, and calculates a charge according to charging data transferred from the digital power meter reader 20 and controls the digital power meter reader 20 and the DCU 30. Therefore, the present invention can easily read the amount of used power without a meterman reading a meter.

That is, to achieve the present invention, at least the digital power meter reader 20, the DCU 30, and the management server 40 are required. Since KEPCO is the main electric power supplier in Korea, KEPCO may utilize this system. If KEPCO is called a manager, the manager owns a separate server 40 to manage this system. In addition, the digital power meter reader 20 is installed in respective houses. The digital power meter reader 20 measures an amount of a pulse of an inflowing current through the CT sensor 23 installed therein. The digital power meter reader measures an amount of current substantially flowing into the house. The measured amount of current corresponds to the amount of power used in each house, and is the same as measured by the conventional mechanical power meter reader 10 installed in the house. The mechanical power meter reader 10 are already installed in each house and the house wishing to utilize the system of the present invention mounts the digital power meter reader 20 of the present invention without removing the mechanical power meter reader 10. When the digital power meter reader 20 is mounted in this way, the amount of power flowing into the house is automatically calculated. The calculated amount of used power is collected in a data collecting device, which is referred to as the DCU 30.

The DCU 30 may be installed on a power pole where a transformer of a village is installed or on a location including a predetermined region as separate equipment after the digital power meter readers 20 are installed in a plurality of houses and a predetermined number of digital power meter readers 20 are accommodated as a group. The DCU 30 collects the amount of used power of each house transferred from the digital power meter reader 20 installed in the house and important information for calculating an amount of other power in the form of data. The DCU 30 may store control signals and information provided by the server 40 in the form of data. When there is an error in the amount of used power displayed on the digital power meter reader 20, the server 40 generates a control signal to correct this error. This control signal may be stored in the DCU 30 and transferred to the digital power meter reader 20 to correct the error.

In this case, there are important matters. The digital power meter reader 20 and the DCU 30 use Power Line Communication (PLC) to exchange information or data with each other. The PLC is a communication method which performs communication by carrying data on a power line in which a current flows, like a flow of a current, and has been frequently used. To carry signals or data on the power line, the signals should be converted and a coupling operation for carrying signals or data on a line should be performed. In addition, complete data is obtained by removing distortion from the signals by filtering the signals or data transferred through the power line, and converting the signals. Through this process, communication between the digital power meter reader 20 and the DCU 30 is completed.

When the amount of current used in a certain house in the meantime is transferred to the DCU 30 through the digital power meter reader 20 using PLC, the DCU 30 transmits corresponding data to the management server 40 (for example, the remote meter reading system server of KEPCO) through mobile communication. The transferred data is the amount of current transferred without a meterman visiting each house. The server 40 trusts the obtained data and calculates a charge. This charging system is stored in the server in the form of a program and thus data can be obtained without a separate process of calculating and collecting charges.

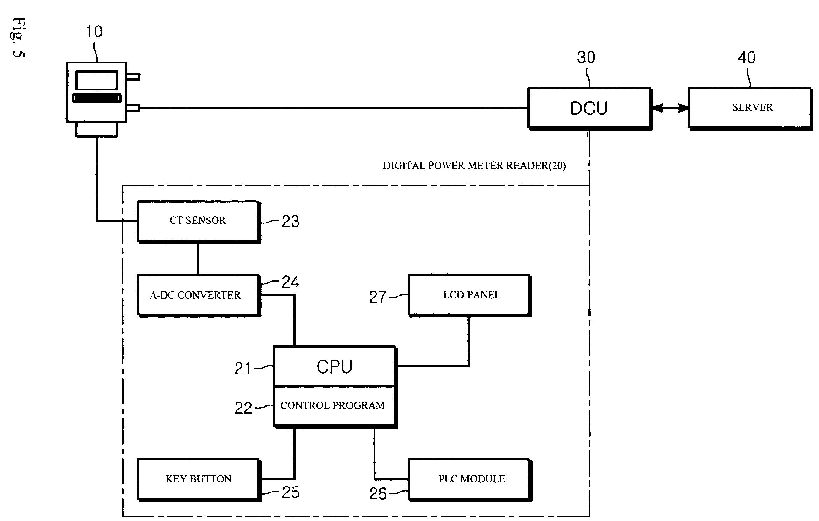

In the above description, the system of the digital power meter reader 20 for at least remote meter reading has been explained. However, the present invention does not satisfy this system and aims at providing various services by adding more precise and detailed elements. Therefore, the detailed system will be explained below with reference to FIG. 5.

That is, the following description relates to the digital power meter reader 20 which is regarded as the most important part in the present invention from among the above-described elements. The digital power meter reader 20 operates as follows and has the following elements.

The digital power meter reader 20 according to the present invention includes: a CT sensor 23 which examines a pulse of an inflowing current and measures an amount of an inflowing current; an A-DC converter 24 which converts analogue usage data measured based on the amount of current into digital data; and a key button 25 which is clicked to set the digital power meter reader 20 and installed to correct or input usage data. In addition, the digital power meter reader 20 further includes: a PLC module 26 which converts, filters, and couples signals and data to transfer the usage data measured in the CT sensor 23 to the DCU 30 through PLC; an LCD panel 27 which displays an amount of used power inputted thereto and displays an amount of power used in the meantime, and expresses a control signal transferred from a CPU 21; and the CPU 21 and a control program 22 embedded in the CPU 21, which controls all of the above-described elements, and controls to convert the current amount pulse read by the CT sensor 21 using the A-DC convert 24, transmit the current amount pulse to the DCU 30 through the PLC module 26, and display the amount of used current expressed on the LCD panel 27 in response to a control signal transferred from the server 40 and the DCU 30. Accordingly, the digital power meter reader 20 measures and corrects the amount of used current, and transmits the amount of used current to the server 40.

The main part of the present invention is the digital power meter reader 20, and the digital power meter reader 20 includes the CT sensor 23, the A-DC converter 24, the key button 25, the LCD panel 27, the PLC module 26, the CPU 21, and the internal control program 22.

The CT sensor 23 measures an amount of current flowing into the digital power meter reader 20. The CT sensor 23 measures an amount of current substantially used in each house. The essential requirement is that this amount of used power should be the same as the amount of power measured by the mechanical power meter reader 10 connected to the digital power meter reader 20, but they may not substantially be the same. The present invention is configured to solve this discrepancy.

The A-DC converter 24 is a device which converts data into an analogue form or convert analogue data into digital data. The CT sensor 23 which obtains the amount of used power in the form of a pulse should transfer corresponding data to the DCU 30. In this case, it is difficult to transfer the signals or data in the analogue form. The signals or data should be converted into digital data and are carried and communicated using PLC. The A-DC converter 24 performs this role.

The key button 25 may be used by the user of each house to correct or modify the amount of used power. The digital power meter reader 20 of the present invention has the separate LCD panel 27 installed in the body thereof to express the amount of used power in real time. However, in a house in which the system of the digital power meter reader 20 for remote meter reading is now being mounted and set, the mechanical power meter reader 10 is being rotated and is measuring the amount of current, but the digital power meter reader 20 is stopped. In this case, when a meterman sets the digital power meter reader 20, the meterman sets by synchronizing the amount of used power of the digital power meter reader 20 and the amount of used power of the mechanical power meter reader 10. It is verified that the same amount of power is used. In this case, the key button 25 is easily used.

The PLC module 26 is a module which converts the obtained information in the analogue form into digital data as described above. That is, the CT sensor 23 obtains all of the amounts of used power in the form of an amount of pulse, and the amount of pulse is an analogue signal. The analogue signal is difficult to transmit to the DCU 30 and thus is converted into the digital form. In this case, the A-DC converter 24 is used. The converted digital data is transferred to the DCU 30 through PLC. The PLC module 26 serves to carry the digital data on a power line and transfer the digital data. The PLC module 26 performs signal conversion when uploading, and performs signal conversion and filtering when coupling and downloading. In this way, the digital power meter reader 20 performs PLC with the DCU 30.

The digital power meter reader 20 of the present invention has the separate CPU 21 embedded therein to perform operations. The operations of the CPU 21 are executing the control program embedded in the CPU 21 and controlling the above-described elements through these operations. The main operations are converting the pulse data of the amount of current read by the CT sensor 23 using the A-DC converter 24 and monitoring the conversion, and controlling when transferring the converted data to the DCU 30. As will be described later, the digital power meter reader 20 may receive a control signal that the server 40 transfers to the DCU 30, and correct the amount of used power which is displayed on the digital power meter reader 20.

A substantially used embodiment will be explained briefly. That is, a process of setting the digital power meter reader 20 and a process of correcting the digital power meter reader 20 will be explained.

### 1. Process of setting the digital power meter reader 20

First, a meterman mounts the digital power meter reader 20 by connecting it with the mechanical power meter reader 10. The meterman synchronizes the amounts of used current of the mechanical power meter reader 10 and the digital power meter reader 20 by clicking the key button 25 of the mounted digital power meter reader 20. When the meterman presses the key button 25 for approving after synchronizing, the amount of used current is transferred to the DCU 30 through PLC, and then data is transferred from the DCU 30 to the server 40. In this case, the meterman may transfer the same or similar information to the server 40 for the accuracy of information using another communicating means.

The server 40 which has received the transferred data generates a control signal and generates a control signal for approving the transferred amount of used power. In this case, this control signal is transferred to the DCU 30 through mobile communication, and the DCU 30 generates a control signal and transfers the control signal to the digital power meter reader 20 through PLC. The control signal approves the amount of used power which is inputted to the digital power meter reader 20 due to the operations of the CPU 21 and the embedded control program 22. This amount of power is an initial amount of used power. Since the amount of used power has been synchronized with the amount of used power of the mechanical power meter reader 10, the mechanical power meter reader 10 and the digital power meter reader 20 read the power simultaneously, and the read data is transferred from the digital power meter reader 20 to the server **40** and this data is a criterion for calculating a charge.

### 2. Process of correcting the digital power meter reader 20

This process is the same as or similar to the process of setting the digital power meter reader 20. First, a user examines the digital power meter reader 20 connected with the mechanical power meter reader 10, and reports when there is a discrepancy in the amounts of used power displayed on both meter readers. The meterman on the spot checks this and synchronizes the amount of used current of the mechanical power meter reader 10 and the amount of used current of the digital power meter reader 20 by clicking the key button 26. That is, the meterman can correct display contents of the digital power meter reader 20. When the meterman presses the key button 26 for approving after synchronizing in this way, the amount of used current is transferred to the DCU 30 through PLC and the DCU 30 transmits data to the server 40. In this case, the meterman may transfer the same or similar information to the server 40 for the accuracy of information using another communicating means.

The server 40 which has received the transferred data generates a control signal and generates a control signal for approving the transferred amount of used power. In this case, this control signal is transferred to the DCU 30 through mobile communication, and the DCU 30 generates a control signal and transfers the control signal to the digital power meter reader 20 through PLC. The control signal corrects and approves the amount of used power of the digital power meter reader 20 due to the operations of the CPU 21 and the embedded control program 22. This amount of power is a re-starting amount of used power. Since the amount of used power has been corrected and synchronized with the amount of used power of the mechanical power meter reader 10, the mechanical power meter reader 10 and the digital power meter reader 20 read the power simultaneously, and the read data is transferred from the digital power meter reader 20 to the server 40 and this data is a criterion for calculating a charge.

Next, a digital power meter reader 20 according to a new exemplary embodiment of the present invention will be explained.

That is, the digital power meter reader 20 shown in FIG. 4 is an exemplary embodiment in which a separate mobile such as a user mobile phone in each house is used.

The digital power meter reader 20 includes: a CT sensor 23 which examines a pulse of a current flowing into the digital power meter reader 20 and measures the amount of the inflowing current; a mobile phone 50 which is a user's terminal of this system, and scans a photo taken for the mechanical power meter reader 10, extracts photo data through an application program 51, and transfers the photo data to an NFC module 60 of the digital power meter reader 20 using an NFC chip 52 embedded in the mobile phone 50; and an A-DC converter 24 which converts analogue usage data measured based on the amount of current into digital data. In addition, the digital power meter reader 20 further includes: a key button 25 which is clicked to set the digital power meter reader 20 and installed to correct or input usage data; a PLC module 26 which converts, filters, and couples signals and data to transfer the usage data measured in the CT sensor 23 to the DCU 30 through PLC; and an LCD panel 27 which displays an amount of used power inputted thereto and displays an amount of power used in the meantime, and expresses a control signal transferred from a CPU 21. In addition, the digital power meter reader 20 further includes the CPU 21 and a control program 22 embedded in the CPU 21, which controls all of the above-described elements, and controls to convert the current amount pulse read by the CT sensor 21 using the A-DC convert 24, transmit the current amount pulse to the DCU 30 through the PLC module 26, and display the amount of used current expressed on the LCD panel 27 in response to a control signal transferred from the server 40 and the DCU 30, and which generates a control signal for transferring, to the DCU 30, the data of the amount of used power of the mechanical power meter reader transferred to the NFC module 60. Accordingly, the digital power meter reader 20 measures and corrects the amount of used current, and transmits the amount of used current to the server 40.

That is, the digital power meter reader 20 according to the second exemplary embodiment of the present invention differs from the digital power meter reader 20 of FIG. 3 in the functions of setting using the mobile phone 50 and inputting an amount of used power to the digital power meter reader 20. That is, the digital power meter reader 20 includes the CT sensor 23, the mobile phone 50 having the NFC chip 52 embedded therein, the A-DC converter 24, the key button 25, the LCD panel 27, the PLC module 26, the CPU 21, and the internal control program 22.

The functions and operating methods of the respective elements will be explained. The CT sensor 23 measures an amount of current flowing into the digital power meter reader 20. The CT sensor 23 measures an amount of current substantially used in each house. The essential requirement is that this amount of used power should be the same as the amount of power measured by the mechanical power meter reader 10 connected to the digital power meter reader 20, but they may not substantially be the same. The present invention is configured to solve this discrepancy.

The mobile phone 50 having the NFC chip 52 embedded therein may adopt two methods to set and correct the digital power meter reader 20. One is directly communicating with the server 40 through the NFC chip 52, and the other one is using a meterman and the key button 25 like the digital power meter reader 20 of the first exemplary embodiment of FIG. 3 described above.

The mobile phone 50 of the present invention is a mobile phone 50 which is substantially pre-approved by the user in each house to utilize the system of the present invention, and has the application program 51 installed therein. The mobile phone 50 executes an application on the application program 51 and photographs the mechanical power meter reader 10 using a camera. The taken photo is scanned by the execution of the application program 51 and read in the form of data. That is, the photographed amount of used current of the mechanical power meter reader, and the number of the machine are read in the form of data. The data is transmitted to the digital power meter reader 20 through the NFC chip 52. The data is transmitted by bring the mobile phone 50 close to the digital power meter reader 20 and clicking a button. In this case, the data may include only the scanned data or photo data and scan data may be transferred simultaneously. The information processing process after the data is transferred in this way is the same as the data processing process of the first exemplary embodiment.

The A-DC converter 24 is a device which converts data into an analogue form or convert analogue data into digital data. The CT sensor 23 which obtains the amount of used power in the form of a pulse should transfer corresponding data to the DCU 30. In this case, it is difficult to transfer the signals or data in the analogue form. The signals or data should be converted into digital data and are carried and communicated using PLC. The A-DC converter 24 performs this role.

The key button 25 may be used by the user of each house to correct or modify the amount of used power. The digital power meter reader 20 of the present invention has the separate LCD panel 27 installed in the body thereof to express the amount of used power in real time. However, in a house in which the system of the digital power meter reader 20 for remote meter reading is now being mounted and set, the mechanical power meter reader 10 is being rotated and is measuring the amount of current, but the digital power meter reader 20 is stopped. In this case, when a meterman sets the digital power meter reader 20, the meterman sets by synchronizing the amount of used power of the digital power meter reader 20 and the amount of used power of the mechanical power meter reader 10. It is verified that the same amount of power is used. In this case, the key button 25 is easily used.

The PLC module 26 is a module which converts the obtained information in the analogue form into digital data as described above. That is, the CT sensor 23 obtains all of the amounts of used power in the form of an amount of pulse, and the amount of pulse is an analogue signal. The analogue signal is difficult to transmit to the DCU 30 and thus is converted into the digital form. In this case, the A-DC converter 24 is used. The converted digital data is transferred to the DCU 30 through PLC. The PLC module 26 serves to carry the digital data on a power line and transfer the digital data. The PLC module 26 performs signal conversion when uploading, and performs signal conversion and filtering when coupling and downloading. In this way, the digital power meter reader 20 performs PLC with the DCU 30.

The digital power meter reader 20 of the present invention has the separate CPU 21 embedded therein to perform operations. The operations of the CPU 21 are executing the control program 22 embedded in the CPU 21 and controlling the above-described elements through these operations. The main operations are converting the pulse data of the amount of current read by the CT sensor 23 using the A-DC converter 24 and monitoring the conversion, and controlling when transferring the converted data to the DCU 30. As will be described later, the digital power meter reader 20 may receive a control signal that the server 40 transfers to the DCU 30, and correct the amount of used power which is displayed on the digital power meter reader 20.

A substantially used embodiment will be explained briefly. That is, a process of setting the digital power meter reader 20 and a process of correcting the digital power meter reader 20 will be explained. An embodiment of the mobile phone having the NFC chip embedded therein will be explained.

### 1. Process of setting the digital power meter reader 20 with the mobile phone 50

First, the user of each house photographs the mechanical power meter reader 10 using the already approved mobile phone 50. The mechanical power meter reader 10 is photographed after the digital power meter reader 20 is connected with the mechanical power meter reader 10 and mounted. When a photo is taken, the application program 51 of the mobile phone 50 is executed to scan the taken photo, and scanned data is transferred to the digital power meter reader 20 using NFC. The digital power meter reader 20 transfers the transferred data to the DCU 30 using PLC. The DCU 30 transfers the transferred data to the server 40 using mobile communication.

This is to synchronize the amount of used current of the mechanical power meter reader 10 and the amount of used current of the digital power meter reader 20. The server 40 checks the approved and transferred data and then generates a control signal for approving.

That is, the server which has received the transferred data generates a control signal for identifying reliability of the data, and generates a control signal for approving the transferred amount of used power. In this case, this control signal is transferred to the DCU 30 through mobile communication, and the DCU 30 generates a control signal and transfers the control signal to the digital power meter reader 20 through PLC. The control signal approves the amount of used power which is inputted to the digital power meter reader 20 due to the operations of the CPU 21 and the embedded control program 22. This amount of power is an initial amount of used power. Since the amount of used power has been synchronized with the amount of used power of the mechanical power meter reader 10, the mechanical power meter reader 10 and the digital power meter reader 20 read the power simultaneously, and the read data is transferred from the digital power meter reader 20 to the server 40 and this data is a criterion for calculating a charge.

### 2. Process of correcting the digital power meter reader 20 with the mobile phone 50

This process is the same as or similar to the process of setting the digital power meter reader 20 with the mobile phone 50. First, the user examines the digital power meter reader 20 connected with the mechanical power meter reader 10, and intends to check and correct when there is a discrepancy in the amounts of used power displayed on both meter readers.

When the application program 51 of the mobile phone is driven and a photo is taken by the camera in the program, the photo is scanned through the application program 51 of the mobile phone 50 as described above, and scanned data is transferred to the digital power meter reader 20 using NFC. The digital power meter reader 20 transfers the transferred data to the DCU 30 using PLC. In this case, a series of processes may be continuously performed or may be performed by pressing the key button 25 of the digital power meter reader 20. The DCU 30 transfers the transferred data to the server 40 using mobile communication.

This is to synchronize the amount of used current of the mechanical power meter reader 10 and the amount of used current of the digital power meter reader 20. The server 40 checks the approved and transferred data and then generates a control signal for approving correction.

That is, the server which has received the transferred data generates a control signal for identifying reliability of the data, and generates a control signal for approving corrections of the transferred amount of used power. In this case, this control signal is transferred to the DCU 30 through mobile communication, and the DCU 30 generates a correction control signal and transfers the correction control signal to the digital power meter reader 20 through PLC. The correction control signal approves the amount of used power which is inputted to the digital power meter reader 20 due to the operations of the CPU 21 and the embedded control program 22. This amount of power is an initial amount of used power. Since the amount of used power has been synchronized with the amount of used power of the mechanical power meter reader 10, the mechanical power meter reader 10 and the digital power meter reader 20 read the power simultaneously, and the read data is transferred from the digital power meter reader 20 to the server and this data is a criterion for calculating a charge.

The present invention is characterized in the system of the digital power meter reader 20 for remote meter reading as described above, and also is characterized in a utilizing method using the same. Therefore, the utilizing method using the system of the digital power meter reader 20 will be explained.

The utilizing method using the system of the digital power meter reader 20 for remote meter reading includes: a first step of setting the digital power meter reader 20, which analyzes an inflowing power pulse through the CT sensor 23 and analyzes an amount of used current, in each house (H) (A100); a second step of synchronizing the amount of used current read through the mechanical power meter reader 10 and the amount of used current of the digital power meter reader 20, and transferring corresponding data to the server 40 for managing (A110); and a third step of, when there is a discrepancy in the amounts of used current displayed on both meter readers while power is used in the house (H), transferring the discrepancy to the server 40, and checking and correcting the amount of used current (A 120), and thus the utilizing method can measure the amount of used current and calculate a charge at a remote distance without a meterman reading a meter.

Each of the steps will be explained in detail below.

The first step is the step of setting the digital power meter reader 20, which analyzes an inflowing power pulse through the CT sensor 23 and analyzes an amount of used current, in each house (H) (A100).

In this step, the digital power meter reader 20 of the present invention is mounted onto the already installed mechanical power meter reader 10. The digital power meter reader 20 and the mechanical power meter reader 10 are connected with each other through a line, such that all of the currents flowing into the mechanical power meter reader 10 pass through the digital power meter reader 20. The mechanical power meter reader 10 and the digital power meter reader 20 may be directly connected with each other without another resistance therebetween, and then the digital power meter reader 20 may be set.

The second step is the step of synchronizing the amount of used current read through the mechanical power meter reader 10 and the amount of used current of the digital power meter reader 20, and transferring corresponding data to the server 40 for managing (A110).

That is, since the system of the present invention is mounted in each house where the mechanical power meter reader 10 is already installed, the amount of used current of the mechanical power meter reader 10 and the amount of used current of the digital power meter reader 20 are synchronized with each other after the digital power meter reader 20 is installed. In this case, the step (A110) of synchronizing the meter readers and transmitting corresponding data to the server 40 in the second step proceeds as follows.

The user may proceed with synchronizing by selectively using the application program 51 of the mobile phone 50 or using the key button 25 of the digital power meter reader 20.

The third step is the step of, when there is a discrepancy in the amounts of used current displayed on both meter readers while power is used in the house (H), transferring the discrepancy to the server 40, and checking and correcting the amount of used current (A120).

That is, the digital power meter reader 20 which has been already set and synchronized, and the mechanical power meter reader 10 are used to display the amounts of used current simultaneously. The mechanical power meter reader 10 and the digital power meter reader 20 are synchronized with each other and thus use the same amount of power, but there may be a discrepancy between both meter readers by long usage. In this case, correction-synchronizing may proceed to make both meter readers identical to each other. This is the case in which the user of the house uses more power than indicated by the mechanical power meter reader 10, and may be preferred when the digital power meter reader 20 displays data.

In this case, the correction-synchronizing proceeds using photo data of the above-described application program 51 and the key button 25. This will be explained in detail below.

That is, if the user selects the application program 51 of the user mobile phone 50 as a synchronizing method from among the above-described synchronizing methods, the following procedure will be performed.

First, the synchronizing method includes: an A step of photographing the mechanical power meter reader 10 with a camera on the application program 51 of the user mobile phone 50, and checking an amount of current used in the meantime (B120); a B step of scanning, by the user mobile phone 50 and the application program 51, the photo and acquiring usage data (B130); and a C step of bringing, by the user, the mobile phone 50 close to the digital power meter reader 20, and receiving, by the digital power meter reader 20, data of the amount of used current using the NFC chip 52 and the NFC module 60 by clicking a transfer button of the application program 51, and transferring the data to the DCU 30 through PLC (B140). In addition, the synchronizing method includes: a D step of acquiring, by the DCU 30, data necessary for using the system of each house and transferring the data to the server 40 through the mobile communication network 31 (B 150); an E step of recognizing, by the server 40, the transferred data as the amount of current used in each house (H) during that time, and then generating a control signal (B160); and an F step of transferring the control signal to the digital power meter reader 20 through the DCU 30 using PLC, and correcting or checking the amount of used current of the digital power meter reader 20, and displaying the amount of used current on the LCD panel 27 (B170). The synchronizing method synchronizes the amounts of used current between the server and the digital power meter reader.

Each of the steps will be explained in detail.

The method goes through the A step of photographing the mechanical power meter reader 10 with a camera on the application program 51 of the user mobile phone 50, and checking an amount of current used in the meantime (B120). In this step, the user connects the digital power meter reader 20 to the mechanical power meter reader 10 first, and photographs the mechanical power meter reader 10 with a camera. The amount of used power read by the mechanical power meter reader 10 and the machine number of the meter reader are photographed. It is determined whether the photo is taken well and then the next step is performed.

The method goes through the B step of scanning, by the user mobile phone 50 and the application program 51, the photo and acquiring usage data (B130). This step is for synchronizing. Since the photo taken by the application program 51 of the mobile phone 50 is in the form of a photo file, the photo is digitalized. That is, usage data is obtained by scanning the photo. If the amount of used current displayed on the mechanical power meter reader is 123 and the machine number of the mechanical power meter reader 10 is No. 9876, it is checked whether the scanned information is 123 and the machine number is 9876 in this step.

Next, the method goes through the C step of bringing, by the user, the mobile phone 50 close to the digital power meter reader 20, and receiving, by the digital power meter reader 20, data of the amount of used current using the NFC chip 52 and the NFC module 60 by clicking a transfer button of the application program 51, and transferring the data to the DCU 30 through PLC (B140). That is, since the amount of used current has been already photographed and scanned with the mobile phone 50, the mobile phone 50 is brought close to the digital power meter reader 20 and data is transmitted using the button on the application program 51. The data is transmitted using NFC. Since the mobile phone 50 is a normal smart phone having the NFC chip 52 embedded therein, the mobile phone 50 can simply communicate with the digital power meter reader 20 only if the NFC module 60 is embedded in the digital power meter reader 20.

The data is transferred in the following way. The taken photo and the scanned data are transmitted to the NFC chip 52 in the mobile phone 50 and transferred to the NFC module 60. The transferred data may be a kind of scanned data or both the scanned data and the photo data. The data is converted through the PLC module 26 and is transferred to the DCU 30.

Next, the method goes through the D step of acquiring, by the DCU 30, data necessary for using the system of each house and transferring the data to the server 40 through the mobile communication network 31 (B150). This step proceeds in real time. The scan data and the photo data transferred in the process of setting in the house are stored in the DCU 30 and transferred to the server 40 again. Preferably, the data is transferred using mobile communication. Since the DCU 30 covering a predetermined range has been already installed and a network for mobile communication has been established in the DCU 30, it is easy to transfer information to the management server 40.

In addition, the method goes through the E step of recognizing, by the server 40, the transferred data as the amount of current used in each house (H) during that time, and then generating a control signal (B160). This step is performed by the manager (for example, KEPCO) who manages the server 40. The manager identifies the photo data and the scan data transferred from the DCU 30, and then approves and processes the data. The manager verifies that the data is reliable information through the photo data and the application program 51 and approves the data as the amount of used current. As the amount of used current is approved, a control signal is generated and transferred to each house.

The method goes through the F step of transferring the control signal to the digital power meter reader 20 through the DCU 30 using PLC, and correcting or checking the amount of used current of the digital power meter reader 20, and displaying the amount of used current on the LCD panel 27 (B170). The control signal generated in the server 40 enters the DCU 30 using mobile communication, and the DCU 30 transfers this control signal to the digital power meter reader 20 using PLC. That is, the control signal is transferred to the digital power meter reader 20 which has transmitted the photo data and the scan data. The transferred control signal is displayed on the LCD panel 27 of the digital power meter reader 20 as a content which is approved by the server as the amount of used current. This step is performed by the operations of the internal control program 22 of the CPU 21. As a result, since the displayed amount of used current is a numerical value which is synchronized with the amount of used current displayed by the mechanical power meter reader 10, the amount of current used measured afterward is added and calculated.

Through the single synchronization operation, the amount of used current of the digital power meter reader 20 is reliable to both the user and the manager. Of course, this data is a criterion for the user to always check data of both meter readers and calculate a charge system.

However, it may be assumed that the digital power meter reader 20 is set by selecting the key button 25 of the digital power meter reader 20 rather than using the mobile phone 50 as described above. That is, when the key button 25 of the digital power meter reader 20 is selected as a synchronizing method, the method includes: an *a* step of inputting the amount of used current of the mechanical power meter reader 10, which is checked by the meterman at the manager side who manages the server 40 with his/her eyes, using the key button 25 of the set digital power meter reader 20 (B180); a *b* step of transferring the inputted amount of used current to the DCU 30 through PLC (B190); and a c step of obtaining, by the DCU 30, data necessary for using the system of each house (H), and transferring the data to the server 40 through the mobile communication network 31 (B150). In addition, the method includes: a *d* step of recognizing, by the server 40, the transferred data as an amount of current used in each house (H) during that time, and then generating a control signal (B160); and an e step of transferring the control signal to the digital power meter reader 20 through the DCU 30 using PLC, correcting or checking the amount of used current of the digital power meter reader 20, and displaying the amount of used current on the LCD panel 27 (B170). Thus, the method synchronizes the amounts of used current between the server 40 and the digital power meter reader 20.

Each of the above-described steps will be explained in detail. First, the method goes through the *a* step of inputting the amount of used current of the mechanical power meter reader 10, which is checked by the meterman at the manager side who manages the server 40 with his/her eyes, using the key button 25 of the set digital power meter reader 20 (B180). In this case, the meterman at the manager side should manage this step. The meterman mounts the digital power meter reader 20 at the side of the mechanical power meter reader 10 and then inputs the amount of used current displayed on the mechanical power meter reader 10 using the key button 25. The content inputted through the key button 25 may be the machine number of the mechanical power meter reader 10, a currently maintained amount of used current, the machine number of the digital power meter reader 20, etc.

Next, the method goes through the *b* step of transferring the inputted amount of used current to the DCU 30 through PLC (B190). When the amount of used current is inputted to the digital power meter reader 20 and the transfer button is clicked, the data is transferred to the DCU 30. The data is transferred using PLC.

The method goes through the c step of obtaining, by the DCU 30, data necessary for using the system of each house (H), and transferring the data to the server 40 through the mobile communication network 31 (B 150).

That is, since a mobile communication network has been established in the DCU 30, the amount of used current, etc. inputted to the digital power meter reader 20 of each house is transferred from the DCU 30 to the server 40 through the mobile communication network.

Next, the method goes through the *d* step of recognizing, by the server 40, the transferred data as an amount of current used in each house (H) during that time, and then generating a control signal (B160).

That is, the information or data inputted through the key button 25 is transferred through the mobile communication network or a power line network managed by the server 40, and is data which has been checked by the meterman. Therefore, the server 40 identifies the information or data as being reliable. After being identified, the information or data is approved and thus a control signal is generated.

Finally, the method goes through the e step of transferring the control signal to the digital power meter reader 20 through the DCU 30 using PLC, correcting or checking the amount of used current of the digital power meter reader 20, and displaying the amount of used current on the LCD panel 27 (B170), and ends with this step.

That is, the control signal generated in the server 40 is transferred to the DCU 30 through the mobile communication network, and the DCU 30 transfers this control signal to the digital power meter reader 20 of each house using the PLC. The CPU 21 of the digital power meter reader 20 receives this control signal and displays corresponding contents on the display panel of the embedded control program 22, that is, the LCD panel 27.

That is, the inputted amount of used current is displayed on the LCD panel 27 and this is the approved amount of used current.

Both meter readers may display different amounts of used current due to long usage even if the same amount of current is always supplied. In this case, a problem arises when the amount of used current displayed on the digital power meter reader 20 is greater than the amount of used current displayed on the mechanical power meter reader 10. This is because the user may pay more charges for electricity.

In this case, the present invention has separate managing and using methods for correcting the amount of used current. In this case, both meter readers should be synchronized. The correction-synchronizing may be performed using the application program 51 of the mobile phone.

That is, the step (A120) of, when there is a discrepancy in the amounts of used current displayed on both meter readers while power is used in each house (H), transmitting the discrepancy to the server 40, and checking and correcting the amount of used current goes through the following steps: a first step of identifying, by the user, the discrepancy in the amounts of used current between the mechanical power meter reader 10 and the digital power meter reader 20 using the application program 51 of the mobile phone 50, and then photographing (B210); a second step of displaying a difference in the amounts of used current and the costs caused by the discrepancy between the meter readers on the application program 51 (B220); and a third step of requesting, by the user, correction by clicking a button on the application program 51 of the mobile phone 50 (B230). In addition, the step (A120) goes through the following steps: a fourth step of scanning a taken photo and reading as data indicating the discrepancy in the amounts of used current, and transferring data for requesting correction to the DCU 30 using NFC (B240); a fifth step of acquiring, by the DCU 30, the data for requesting correction, and transferring the data to the server 40 through the mobile communication network 31 (B250); and a sixth step of recognizing, by the server 40, the transferred data as an amount of current used in the house which requests the correction, and generating a control signal (B260). In addition, the step (A120) is completed by going through a seventh step of transferring the control signal to the digital power meter reader 20 through the DCU 30 using PLC, correcting the amount of used current of the digital power meter reader 20, and displaying and checking the amount of used current on the LCD panel 270 (B270). Therefore, the amounts of used current of the server 40 and the digital power meter reader 20 are corrected and synchronized with each other.

Each of the steps of the correction-synchronizing method will be explained in sequence.

First, the first step of identifying, by the user, the discrepancy in the amounts of used current between the mechanical power meter reader 10 and the digital power meter reader 20 using the application program 51 of the mobile phone 50, and then photographing (B210) is as follows.

This is the case in which there is a discrepancy in the amounts of used current between the mechanical power meter reader 10 and the digital power meter reader 20 in the middle of using the system of the present invention after the digital power meter reader 20 has been set or correction-synchronizing has been already performed. When the discrepancy falls out of a threshold value, the user drives the application program 51 using the user's mobile phone 50. Since a camera is mounted in the application program 51 in the mobile phone 50 as a program, the mechanical power meter reader 10 is photographed using this camera program.

The method goes through the second step of displaying a difference in the amounts of used current and the costs caused by the discrepancy between the meter readers on the application program 51 (B220). Since the application program 51 has the charge management system required by the manager server 40, the usage calculating method, etc. embedded therein, a difference in the costs between the different amounts of used current is displayed. The user who does not accept the difference in the costs should solve this problem by correcting the amount of used current. This method is preferred when the amount of used current in the digital power meter reader 20 is higher than that of the mechanical power meter reader 10.

Next, the method goes through the third step of requesting, by the user, correction by clicking a button on the application program 51 of the mobile phone 50 (B230). When a button for requesting correction of the difference displayed on the application program 51 is clicked, the control signal is transferred to the DCU 30, which is the next step.

The method goes through the fourth step of scanning a taken photo and reading as data indicating the discrepancy in the amounts of used current, and transferring data for requesting correction to the DCU 30 using NFC (B240). The taken photo is scanned on the application program 51 and read as data indicating the discrepancy in the amounts of used current, and is transferred to the DCU 30 using NFC. Since the discrepancy in the amounts of used current is a target to be corrected, the DCU 30 which receives the data transfers the data to the server 40. All of the subsequent processes are the same as the above-described setting processes.

## Claims

1. A digital power meter reader system for remote meter reading, which easily reads an amount of used power without a meterman reading a power meter, the system comprising:
a digital power meter reader 20 which is connected to a mechanical power meter reader 10 installed in each house (H), and measures an amount of power flowing into the house through a CT sensor 23 disposed therein and transfers the measured data to a DCU 30 through PLC;
the DCU 30 which transfers the amount of used power and relevant data transmitted from the digital power meter reader 20 of each house to a server 40 for computing power through a mobile communication network 31, and which transfers a signal for correcting the amount of used power of the digital power meter reader 20 through the PLC according to a control signal transferred from the server 40; and
the server 40 (for example, a server of KEPCO) which has a charging system for charging each house for supplied power, and which computes a usage charge according to charging data transferred from the digital power meter reader 20 and controls the digital power meter reader 20 and the DCU 30.

2. The digital power meter reader system of claim 1, wherein the digital power meter reader 20 comprises:
the CT sensor 23 which examines a pulse of an inflowing current and measures an amount of the inflowing current;
an A-DC converter 24 which converts analogue usage data measured based on an amount of current into digital data;
a key button 25 which is clicked to set the digital power meter reader 20 and installed to correct or input usage data;
a PLC module 26 which converts, filters, and couples a signal and data to transfer the usage data measured by the CT sensor 23 to the DCU 30 through the PLC;
an LCD panel 27 which displays the input amount of used power and displays an amount of power used in the meantime, and expresses a control signal transferred from a CPU 21; and
the CPU 21 and a control program 22 embedded in the CPU 21 which control all of the above-described elements, and control to convert a current amount pulse read by the CT sensor 23 using the A-DC converter 24, transfer the current amount pulse to the DCU 30 through the PLC module 26, and display the amount of used current expressed on the LCD panel 27 in response to a control signal transferred from the server 40 and the DCU 30, and
wherein the digital power meter reader is configured to measure the amount of used current, correct the amount of used current, and transfer the amount of used current to the server 40.

3. The digital power meter reader system of claim 2, wherein the digital power meter reader 20 comprises:
the CT sensor 23 which examines a pulse of an inflowing current and measures an amount of the inflowing current;
a mobile phone 50 which is a terminal of a user of the system, and which scans a photo taken for the mechanical power meter reader 10, extracts photo data through an application program 51, and transfers the photo data to an NFC module 60 of the digital power meter reader 20 using an NFC chip 52 embedded in the mobile phone 50;
an A-DC converter 24 which converts analogue usage data measured based on an amount of used current into digital data;
a key button 25 which is clicked to set the digital power meter reader 20 and installed to correct or input usage data;
a PLC module 26 which converts, filters, and couples a signal and data to transfer the usage data measured by the CT sensor 23 to the DCU 30 through the PLC;
an LCD panel 27 which displays the input amount of used power and displays an amount of power used in the meantime, and expresses a control signal transferred from a CPU 21; and
the CPU 21 and a control program 22 embedded in the CPU 21 which control all of the above-described elements, and control to convert a current amount pulse read by the CT sensor 23 using the A-DC converter 24, transfer the current amount pulse to the DCU 30 through the PLC module 26, and display the amount of used current expressed on the LCD panel 27 in response to a control signal transferred from the server 40 and the DCU 30, and which generate a control signal for transferring, to the DCU 30, data of an amount of used power of the mechanical power meter reader transferred to the NFC module 60, and
wherein the digital power meter reader is configured to measure an amount of used current, correct the amount of used current, and transfer the amount of used current to the server 40.

4. A utilizing method using a digital power meter reader 20 system for remote meter reading, which reads an amount of used current at a remote distance without a meterman reading a meter, and computes a charge, the method comprising:
a first step of setting, in each house (H), a digital power meter reader 20 for analyzing an inflowing power pulse through a CT sensor 23 and analyzing an amount of used current (A100);
a second step of synchronizing an amount of used current read through a mechanical power meter reader 10 and an amount of used current of the digital power meter reader 20, and transferring the synchronized amount of used current to a server 40 for managing (A 110); and
a third step of, when there is a discrepancy in the amounts of used current displayed on both meter readers while power is used in each house (H), transmitting the discrepancy to the server 40, and checking and correcting the amount of used current (A120).

5. The utilizing method of claim 4, wherein the step (A110) of synchronizing the meter readers and transmitting synchronized data to the server 40 proceeds with synchronizing by a user using an application program 51 of a mobile phone 50 or using a key button 25 of the digital power meter reader 20.

6. The utilizing method of claim 5, wherein, when the application program 51 of the user mobile phone 50 is selected as a synchronizing method, the step of synchronizing comprises:
an A step of photographing the mechanical power meter reader 10 with a camera on the application program 51 using the user mobile phone 50, and checking an amount of current used in the meantime (B120);
a B step of scanning, by the user mobile phone 50 and the application program 51, the taken photo, and acquiring usage data (B130);
a C step of bringing, by the user, the mobile phone 50 close to the digital power meter reader 20, and receiving, by the digital power meter reader 20, data of an amount of used current using an NFC chip 52 and an NFC module 60 by clicking a transfer button on the application program 51, and transferring the data to a DCU 30 through PLC (B140);
a D step of acquiring, by the DCU 30, data necessary for using the system of each house, and transferring the data to the server 40 through a mobile communication network 31 (B 150);
an E step of recognizing, by the server 40, the transferred data as an amount of current used in each house (H), and then generating a control signal (B160); and
an F step of transferring the control signal to the digital power meter reader 20 through the DCU 30 using the PLC to correct or check the amount of used current of the digital power meter reader 20, and displaying the amount of used current on an LCD panel 27 (B170), and synchronizes the amounts of used current between the server and the digital power meter reader.

7. The utilizing method of claim 5, wherein, when the key button 25 of the digital power meter reader 20 is selected as a synchronizing method, the step of synchronizing comprises:
an *a* step of inputting an amount of used current of the mechanical power meter reader 10 which is checked by a meterman at a manager side managing the server 40 with meterman's eyes using the key button 25 of the digital power meter reader 20 (B180);
a b step of transferring the inputted amount of used current to a DCU 30 through PLC (B190);
a c step of acquiring, by the DCU 30, data necessary for using the system of each house (H) and transferring the data to the server 40 through the mobile communication network 31 (B 150);
a d step of recognizing, by the server 40, the transferred data as an amount of current used in each house (H) in the meantime, and then generating a control signal (B160); and
an e step of transferring the control signal to the digital power meter reader 20 through the DCU 30 using the PLC to correct or check the amount of used current of the digital power meter reader 20, and displaying the amount of used current on an LCD panel 27 (B170), and synchronizes the amounts of used current between the server 40 and the digital power meter reader 20.

8. The utilizing method of claim 4, wherein the step (A120) of, when there is a discrepancy in the amounts of used current displayed on both meter readers while power is used in each house (H), transmitting the discrepancy to the server 40, and checking and correcting the amount of used current comprises:
a first step of identifying, by the user, the discrepancy in the amounts of used current between the mechanical power meter reader 10 and the digital power meter reader 20 using the application program 51 of the mobile phone 50, and photographing (B210);
a second step of displaying a difference in the amounts of used current and costs caused by the discrepancy between both meter readers on the application program 51 (B220);
a third step of requesting, by the user, correction by clicking a button on the application program 51 of the mobile phone 50 (B230);
a fourth step of scanning a taken photo and reading as data indicating the discrepancy in the amounts of used current, and transferring data for requesting correction to a DCU 30 using NFC (B240);
a fifth step of acquiring, by the DCU 30, the data for requesting the correction, and transferring the data to the server 40 using a mobile communication network 31 (B250);
a sixth step of recognizing, by the server 40, the transferred data as an amount of current used in the house requesting the correction, and then generating a control signal (B260); and
a seventh step of transferring the control signal to the digital power meter reader 20 through the DCU 30 using PLC to correct the amount of used current of the digital power meter reader 20, and displaying and checking the amount of used current on an LCD panel 27 (B270), and synchronizes the amounts of used current between the server 40 and the digital power meter reader 20.
